# EUROPEAN PATENT APPLICATION

(11) **EP 4 636 825 A1**
(43) Date of publication of application: **22.10.2025**
(21) Application number: 23915525.2
(22) Date of filing: 13.06.2023
(51) Int. Cl.: H01L 23/552

(54) **BARE CHIP, CHIP AND ELECTRONIC DEVICE**

(30) Priority: 10.01.2023 CN 202310030208
(71) Applicant: Honor Device Co., Ltd., Shenzhen, Guangdong 518040 (CN)
(72) Inventor: SHI, Lin, Shenzhen, Guangdong 518040 (CN); QU, Lin, Shenzhen, Guangdong 518040 (CN); HUO, Haohui, Shenzhen, Guangdong 518040 (CN); HONG, Weiqiang, Shenzhen, Guangdong 518040 (CN)
(74) Representative: Thun, Clemens
(86) International application number: PCT/CN2023/100024
(87) International publication number: WO 2024/148762

(57) **Abstract**

This application discloses a bare chip, a chip, and an electronic device, which relate to the technical field of semiconductor devices and can improve the anti-ionizing radiation capability of the chip. The bare chip includes: a substrate layer, a circuit layer, an insulation layer, and a shield layer. The circuit layer is disposed on a surface of a side of the substrate layer. The insulation layer is disposed on a surface of a side of the circuit layer facing away from the substrate layer. The shield layer is disposed on a surface of a side of the insulation layer facing away from the substrate layer. The shield layer is configured to shield ionizing radiation.

## Description

This application claims priority to Chinese Patent Application No. 202310030208.7, entitled "BARE CHIP, CHIP, AND ELECTRONIC DEVICE", and filed with the China National Intellectual Property Administration on January 10, 2023, which is incorporated herein by reference in its entirety.

### TECHNICAL FIELD

This application relates to the technical field of semiconductor devices, and in particular, to a bare chip, a chip, and an electronic device.

### BACKGROUND

An electronic system usually refers to an objective entity composed of electronic components or parts, which can generate, transmit, acquire, or process electrical signals and information. With the in-depth development of information and intelligence, electronic systems are more and more widely used in mobile phones, computers, automotive electronics, industrial control, and other electronic devices.

The core component in an electronic system is a chip, and the stability of a chip structure determines the stability of the electronic system. However, in the prior art, the anti-ionizing radiation capability of the chip is poor. When the chip is used in an environment where ionizing radiation exists, the ionizing radiation is apt to interact with internal electrons of the chip, causing the chip to malfunction and affecting the stability and reliability of the chip.

### SUMMARY

Embodiments of this application provide a bare chip, a chip, and an electronic device, for improving the anti-ionizing radiation capability of the chip.

To achieve the foregoing objective, the following technical solutions are used in the embodiments of this application:

In a first aspect, an embodiment of this application provides a bare chip, including: a substrate layer, a circuit layer, an insulation layer, and a shield layer. The circuit layer is disposed on a surface of a side of the substrate layer. The insulation layer is disposed on a surface of a side of the circuit layer facing away from the substrate layer. The shield layer is disposed on a surface of a side of the insulation layer facing away from the substrate layer. The shield layer is configured to shield ionizing radiation.

In the bare chip in this embodiment of this application, by disposing the shield layer on the surface of the side of the insulation layer of the bare chip facing away from the substrate layer, the ionizing radiation from the outside of the bare chip can be shielded by the shield layer, the anti-ionizing radiation capability of the bare chip can be significantly improved, and further the ionizing radiation resistance capability of the chip including the bare chip can be improved. Therefore, on one hand, normal operation of the chip in a harsh environment in which ionizing radiation exists can be ensured. On the other hand, system redundancy design of the chip is not needed, waste of resources can be avoided, and the economic efficiency can be improved. Further, a metal housing structure of the chip can be omitted, and the material of the package structure of the chip can be improved, so as to reduce the overall cost of the chip while implementing a miniaturized design of the chip.

In a possible implementation of the first aspect, the shield layer includes a first film layer, which is a compound film layer including a bismuth element (Bi) or a titanium element (Ti). The bismuth element and the titanium element have stable properties, and can generate an electron pair effect with X-rays. By configuring the first film layer as the compound film layer including the bismuth element (Bi) or the titanium element (Ti), X-rays can be shielded through the first film layer, and damage to the bare chip by high-energy radiation such as X-rays can be reduced.

In a possible implementation of the first aspect, the first film layer is disposed on a surface of a side of the insulation layer facing away from the substrate layer.

In a possible implementation of the first aspect, a material of the insulation layer may be silicon dioxide (SiO2), aluminum nitride (AlN), or gallium nitride (GaN). In this way, the degree of matching between the first film layer and the insulation layer can be improved, and growth of a crystal material of the first film layer on the surface of the insulation layer is facilitated, so that the formation of the first film layer on the surface of the insulation layer is facilitated, and the bonding strength between the first film layer and the insulation layer is ensured.

In a possible implementation of the first aspect, the first film layer may be a bismuth trioxide (Bi2O3) film layer or a barium titanate (BaTiO3) film layer. The Bi2O3 and BaTiO3 have stable physical and chemical properties, low prices, and wide sources, and are easy to obtain.

In a possible implementation of the first aspect, a thickness t1 of the first film layer is greater than or equal to 1 µm and less than or equal to 3 µm. For example, the thickness t1 of the first film layer may be 1 µm, 1.5 µm, 2 µm, 2.5 µm, 3 µm, or the like. In this way, the overall thickness of the bare chip can be reduced while the X-ray shielding effect of the first film layer is ensured, thereby facilitating reduction of the overall thickness of the chip and implementing a miniaturized design of the chip.

In a possible implementation of the first aspect, the first film layer may be formed by using a physical vapor deposition method such as vacuum sputtering or vacuum evaporation, or the first film layer may alternatively be formed on the surface of the insulation layer by using a chemical vapor deposition method. The process is simple and the processing is convenient.

In a possible implementation of the first aspect, the shield layer includes a second film layer and the second film layer is a compound film layer including a boron element or a lithium element. The boron element and the lithium element have a high absorption cross-section for neutrons, and after absorbing neutrons, the boron element and lithium element generate less secondary γ rays, and the boron element and lithium element do not interfere with operation of the bare chip. In this way, by configuring the second film layer as the compound film layer including the boron element or the lithium element, neutrons can be effectively shielded, and the radiation impact of high-energy particles such as neutrons on the bare chip can be reduced, thereby improving the anti-ionizing radiation capability of the bare chip and the chip including the bare chip.

In a possible implementation of the first aspect, the shield layer includes a second film layer, the second film layer is a compound film layer including a boron element or a lithium element, and the second film layer is located on a side of the first film layer facing away from the insulation layer, or the first film layer is located on a side of the second film layer facing away from the insulation layer. Therefore, the shield layer in this embodiment not only can resist high-energy radiation of X-rays, but also can resist high-energy radiation of high-energy particles such as neutrons, so that the bare chip can resist different types of ionizing radiation, thereby significantly improving the anti-ionizing radiation capability of the bare chip and the chip.

In a possible implementation of the first aspect, the second film layer is a boron nitride film layer or a boron carbide film layer. The BN and BC have stable physical and chemical properties and wide sources, and are easy to obtain.

In a possible implementation of the first aspect, a thickness t3 of the second film layer is greater than or equal to 1 µm and less than or equal to 3 µm. For example, the thickness t3 of the second film layer may be 1 µm, 1.5 µm, 2 µm, 2.5 µm, 3 µm, or the like. In this way, the overall thickness of the bare chip can be reduced while the neutron shielding effect of the second film layer is ensured, thereby further facilitating reduction of the overall thickness of the chip and implementing a miniaturized design of the chip.

In a possible implementation of the first aspect, the shield layer further includes a transition layer, the first film layer and the second film layer are fixedly connected to two opposite sides of the transition layer respectively, and a material of the transition layer is silicon dioxide, aluminum nitride, or gallium nitride. In this way, the transition layer, the first film layer, and the second film layer all have a high degree of matching. In a processing process, not only the transition layer can be conveniently formed on the surface of the first film layer facing away from the insulation layer, but also the second film layer can be conveniently formed on the surface of the transition layer facing away from the first film layer, so that the connection reliability between the first film layer and the transition layer and the connection reliability between the second film layer and the transition layer can be improved, and a phenomenon of delaminating and falling off of the shield layer can be avoided; and therefore the stability and reliability of the overall structure of the shield layer can be improved and the shielding effect of the shield layer against ionizing radiation can be ensured.

In a possible implementation of the first aspect, the shield layer includes a first composite material layer, the first composite material layer is disposed on a surface of a side of the first film layer facing away from the insulation layer, the first composite material layer includes a matrix and first nano-particles, the first nano-particles are dispersed in the matrix, and the first nano-particles include at least one of boron nitride nano-particles or boron carbide nano-particles. In this way, neutrons can be absorbed by the boron element in the first composite material layer, so that the radiation impact of high-energy particles such as neutrons on the bare chip and the chip can be reduced. Therefore, the shield layer in this embodiment can resist both high-energy radiation of X-rays and high-energy radiation of high-energy particles such as neutrons, so that the bare chip can resist different types of ionizing radiation, thereby significantly improving the anti-ionizing radiation capability of the bare chip, and further improving the anti-ionizing radiation capability of the chip. In addition, the first composite material layer is disposed on a surface of a side of the first film layer facing away from the insulation layer, so that the first film layer can be prevented from being exposed. Therefore, the first film layer can be protected by using the first composite material layer, and the first film layer can be prevented from being affected with moisture or being corroded.

In a possible implementation of the first aspect, the shield layer includes a first composite material layer, the first composite material layer is disposed on a surface of a side of the first film layer facing away from the insulation layer, the first composite material layer includes a matrix and first nano-particles, the first nano-particles are dispersed in the matrix, and the first nano-particles include at least one of boron nitride nano-particles or boron carbide nano-particles. In this way, neutrons can be absorbed by the boron element in the first composite material layer, so that the radiation impact of high-energy particles such as neutrons on the bare chip can be reduced, and further the anti-ionizing radiation capability of the chip can be improved.

In a possible implementation of first aspect, a material of the matrix is a polymer material. In this way, on one hand, mixing of the first nano-particles and the matrix is facilitated, so that the first nano-particles are dispersed in the matrix. On the other hand, not only the neutrons can be absorbed by the boron element in the first composite material layer, but also the energy of neutrons can be reduced through interaction between hydrogen atoms in the polymer material and the neutrons, to achieve the purpose of attenuating and slowing the neutrons, so that the shielding effect of the first composite material layer on the neutrons can be further improved, the radiation impact of the high-energy particles such as the neutrons on the bare chip can be reduced, and further the anti-ionizing radiation capability of the bare chip can be improved and in turn the anti-ionizing radiation capability of the chip can be improved.

In a possible implementation of the first aspect, a material of the matrix may include, but is not limited to, at least one of polyimide, polyethylene terephthalate, or polyethylene.

In a possible implementation of the first aspect, the bare chip further includes a surface protection layer and the surface protection layer is disposed on a surface of a side of the shield layer facing away from the insulation layer. The surface protection layer can shield the shield layer to prevent the shield layer from being exposed, so that the shield layer can be protected by the surface protection layer to prevent the shield layer from being corroded or affected with moisture.

In a possible implementation of the first aspect, the surface protection layer is a polymer material layer. For example, a material of surface protection layer may include, but is not limited to, polyimide, polyethylene terephthalate, polyethylene, or the like. The polymer material has stable properties and strong corrosion resistance. By disposing the polymer material layer on the shield layer as the surface protection layer, the shield layer can be protected by the surface protection layer to prevent the shield layer from being corroded. In addition, the polymer material layer has good mechanical properties. By disposing the surface protection layer on the shield layer, the overall anti-impact capability of the bare chip can further be improved. In addition, the content of hydrogen atoms in the polymer material is relatively high, and the hydrogen atoms interact with neutrons to reduce neutron energy and achieve the effect of attenuating and slowing the neutrons, so that the radiation impact of high-energy particles such as the neutrons on the bare chip can be reduced, and further the anti-ionizing radiation capability of the bare chip is improved and in turn the anti-ionizing radiation capability of the chip can be improved.

In a possible implementation of the first aspect, a thickness t2 of the surface protection layer is greater than or equal to 1 µm and less than or equal to 3 µm. For example, the thickness t2 of the surface protection layer may be 1 µm, 1.5 µm, 2 µm, 2.5 µm, 3 µm, or the like. In this way, the overall thickness of the bare chip can be reduced while the protection effect of the surface protection layer is ensured, thereby further facilitating reduction of the overall volume of the chip and implementing a miniaturized design of the chip.

In a possible implementation of the first aspect, the shield layer includes a second film layer, the second film layer is located on a side of the insulation layer facing away from the substrate layer, and the second film layer is a compound film layer including a boron element or a lithium element.

In a possible implementation of the first aspect, the shield layer includes a second composite material layer, the second composite material layer is disposed on a surface of a side of the second film layer facing away from the insulation layer, the second composite material layer includes a matrix and second nano-particles, the second nano-particles are dispersed in the matrix, and the second nano-particles include at least one of bismuth trioxide nano-particles or barium titanate nano-particles. In this way, X-rays can be shielded by the bismuth element or the titanium element in the second composite material layer, and the radiation impact of high-energy particles such as X-rays on the bare chip can be reduced. Therefore, the shield layer in this embodiment can resist both high-energy radiation of X-rays and high-energy radiation of high-energy particles such as neutrons, so that the bare chip can resist different types of ionizing radiation, thereby significantly improving the anti-ionizing radiation capability of the bare chip and the chip. In addition, the second composite material layer is disposed on a surface of a side of the second film layer facing away from the insulation layer, so that the second film layer can be prevented from being exposed. Therefore, the second film layer can be protected by using the second composite material layer, and the second film layer can be prevented from being affected with moisture or corroded.

In a possible implementation of the first aspect, the shield layer includes a second composite material layer and the second composite material layer is disposed on a surface of a side of the insulation layer facing away from the substrate layer. The second composite material layer includes a matrix and second nano-particles, the second nano-particles are dispersed in the matrix, and the second nano-particles include at least one of bismuth trioxide nano-particles or barium titanate nano-particles. In this way, X-rays can be shielded by the bismuth element or the titanium element in the second composite material layer, and the radiation impact of high-energy particles such as X-rays on the bare chip can be reduced, and further the anti-ionizing radiation capability of the chip can be improved.

In a possible implementation of the first aspect, the shield layer includes a third composite material layer, the third composite material layer is disposed on a side of the insulation layer facing away from the substrate layer, the third composite material layer includes a matrix, first nano-particles, and second nano-particles, the first nano-particles and the second nano-particles are dispersed in the matrix, the first nano-particles include at least one of boron nitride nano-particles or boron carbide nano-particles, and the second nano-particles include at least one of bismuth trioxide nano-particles or barium titanate nano-particles. Therefore, the shield layer in this embodiment can resist both high-energy radiation of X-rays and high-energy radiation of high-energy particles such as neutrons, so that the bare chip can resist different types of ionizing radiation, thereby significantly improving the anti-ionizing radiation capability of the bare chip, and further improving the anti-ionizing radiation capability of the chip. In addition, the structure of the shield layer in this embodiment is simple, which is more conducive to reducing the overall thickness of the shield layer, thereby reducing the overall volume of the chip and implementing a miniaturized design of the chip.

In a possible implementation of the first aspect, a particle diameter of the first nano-particles is less than or equal to 100 nm. In this way, on one hand, mixing between the first nano-particles and the matrix is facilitated, thereby facilitating improvement of the degree of dispersion of the first nano-particles in the matrix and improvement of the shielding effect of the first composite material layer. On the other hand, the flatness of the surface of the first composite material layer can be ensured, thereby preventing the first nano-particles from damaging other structures such as the first film layer in the bare chip.

In a possible implementation of the first aspect, a particle diameter of the first nano-particles is greater than or equal to 50 nm. For example, the particle diameter of the first nano-particles is 100 nm, 95 nm, 90 nm, 85 nm, 80 nm, 75 nm, 70 nm, 65 nm, 60 nm, 55 nm, 50 nm, or the like.

In a possible implementation of the first aspect, a particle diameter of the second nano-particles is greater than or equal to 50 nm and less than or equal to 100 nm.

In a possible implementation of the first aspect, a thickness of the shield layer is less than or equal to 10 µm. For example, the thickness of shield layer is 10 µm, 9 µm, 8 µm, 7 µm, 6 µm, 5 µm, 4 µm, 3 µm, 2 µm, or 1 µm. In this way, the overall thickness of the bare chip can be reduced while the shielding effect of the shield layer is ensured, thereby further facilitating reduction of the overall volume of the chip and implementing a miniaturized design of the chip.

In a second aspect, an embodiment of this application provides a chip. The chip includes a package base plate, a bare chip, and a plastic package body. The bare chip is the bare chip in any one of the foregoing technical solutions, the bare chip is electrically connected to the package base plate, the plastic package body is disposed on the package base plate, and the plastic package body is wrapped outside the bare chip.

In a third aspect, an embodiment of this application provides an electronic device, including a circuit board and a chip. The chip is electrically connected to the circuit board, and the chip is the chip in any one of the foregoing technical solutions.

In a possible implementation of the third aspect, the chip is electrically connected to the circuit board by using the package base plate.

In a possible implementation of the third aspect, the electronic device includes: a screen and a back housing. The screen includes a light-transmitting cover plate and a display screen. The light-transmitting cover plate and the display screen are stacked. The back housing includes a back cover and a border frame. The back cover is located on a side of the display screen facing away from the light-transmitting cover plate, and is stacked with the light-transmitting cover plate and the display screen. The border frame is located between the back cover and the light-transmitting cover plate, and the border frame is fixed on the back cover. The light-transmitting cover plate, the back cover, and the border frame form an internal accommodating space of the electronic device. The circuit board is disposed in the internal accommodating space.

In a fourth aspect, this application provides a method for preparing a bare chip, including: providing a bare chip blank, where the bare chip blank includes a substrate layer, a circuit layer, and an insulation layer, the circuit layer is disposed on a surface of a side of the substrate layer, and the insulation layer is disposed on a surface of a side of the circuit layer facing away from the substrate layer; and forming a shield layer on a surface of a side of the insulation layer facing away from the substrate layer.

In a possible implementation of the fourth aspect, forming a shield layer on a surface of a side of the insulation layer facing away from the substrate layer includes: forming a first film layer on the surface of the side of the insulation layer facing away from the substrate layer.

In a possible implementation of the fourth aspect, the first film layer is formed by using a physical vapor deposition method or a chemical vapor deposition method.

In a possible implementation of the fourth aspect, forming a shield layer on a surface of a side of the insulation layer facing away from the substrate layer includes: forming a first film layer on the surface of the side of the insulation layer facing away from the substrate layer; forming a transition layer on a surface of a side of the first film layer facing away from the insulation layer; and forming a second film layer on a surface of a side of the transition layer facing away from the first film layer.

In a possible implementation of the fourth aspect, the second film layer is formed by using a physical vapor deposition method or a chemical vapor deposition method.

In a possible implementation of the fourth aspect, the transition layer is formed by using a physical vapor deposition method or a chemical vapor deposition method.

In a possible implementation of the fourth aspect, forming a shield layer on a surface of a side of the insulation layer facing away from the substrate layer includes: forming a second film layer on the surface of the insulation layer facing away from the substrate layer.

In a possible implementation of the fourth aspect, forming a shield layer on a surface of a side of the insulation layer facing away from the substrate layer includes: forming a second film layer on a surface of a side of the insulation layer facing away from the substrate layer; forming a transition layer on a surface of a side of the second film layer facing away from the insulation layer; and forming a first film layer on a surface of a side of the transition layer facing away from the second film layer.

In a possible implementation of the fourth aspect, forming a shield layer on a surface of a side of the insulation layer facing away from the substrate layer includes: forming a first film layer on the surface of the side of the insulation layer facing away from the substrate layer; and forming a first composite material layer on a surface of a side of the first film layer facing away from the insulation layer.

In a possible implementation of the fourth aspect, the first composite material layer is coated on the surface of the side of the first film layer facing away from the insulation layer.

In a possible implementation of the fourth aspect, forming a shield layer on a surface of a side of the insulation layer facing away from the substrate layer includes: forming a second film layer on a surface of a side of the insulation layer facing away from the substrate layer; and forming a second composite material layer on a surface of a side of the second film layer facing away from the insulation layer.

In a possible implementation of the fourth aspect, the second composite material layer is coated on a surface of a side of the second film layer facing away from the insulation layer.

In a possible implementation of the fourth aspect, forming a shield layer on a surface of a side of the insulation layer facing away from the substrate layer includes: forming a third composite material layer on the surface of the side of the insulation layer facing away from the substrate layer.

In a possible implementation of the fourth aspect, the third composite material layer is coated on the surface of the side of the insulation layer facing away from the substrate layer.

In a possible implementation of the fourth aspect, after forming a shield layer on a surface of a side of the insulation layer facing away from the substrate layer, the method further includes: forming a surface protection layer on a surface of a side of the shield layer facing away from the insulation layer.

In a possible implementation of the fourth aspect, the surface protection layer is coated on the surface of the side of the shield layer facing away from the insulation layer.

In a fifth aspect, an embodiment of this application provides an electronic device, including a circuit board and a bare chip. The bare chip is electrically connected to the circuit board. The bare chip is the bare chip in any one of the foregoing technical solutions.

For the technical effects brought by any one of the design manners in the second aspect to the fifth aspect, reference may be made to the technical effects brought by different design manners in the first aspect, and details are not described herein again.

### BRIEF DESCRIPTION OF DRAWINGS

FIG. 1 is a three-dimensional view of an electronic device according to some embodiments of this application;
FIG. 2 is an exploded view of the electronic device shown in FIG. 1;
FIG. 3 is a schematic assembly diagram of a chip and a circuit board according to some embodiments of this application;
FIG. 4 is a schematic structural diagram of a bare chip according to an embodiment of this application;
FIG. 5 is a cross-sectional view of a circuit layer of the bare chip shown in FIG. 4;
FIG. 6 is a schematic structural diagram of a bare chip according to some other embodiments of this application;
FIG. 7 is a schematic structural diagram of a bare chip according to some other embodiments of this application;
FIG. 8 is a schematic structural diagram of a bare chip according to still some other embodiments of this application;
FIG. 9 is a schematic structural diagram of a bare chip according to still some other embodiments of this application;
FIG. 10 is a schematic structural diagram of a bare chip according to still some other embodiments of this application;
FIG. 11 is a schematic structural diagram of a bare chip according to still some other embodiments of this application;
FIG. 12 is a schematic structural diagram of a bare chip according to still some other embodiments of this application;
FIG. 13 is a schematic structural diagram of a bare chip according to still some other embodiments of this application;
FIG. 14 is a schematic structural diagram of a bare chip according to still some other embodiments of this application; and
FIG. 15 is a schematic structural diagram of a bare chip according to still some other embodiments of this application.

### Reference numerals:

100. electronic device;
10. screen; 11. light-transmitting cover plate; 12. display screen;
20. back housing; 21. back cover; 22. border frame; 23. middle plate;
30. circuit board assembly; 301. circuit board; 302. electronic component; 303. chip; 31. package base plate;
32. bare chip; 32a. hollow structure; 321. substrate layer; 322. circuit layer; 3221. metal layer; 3222. dielectric layer; 323. insulation layer; 324. shield layer; 3241. first film layer; 3242. second film layer; 3243. transition layer; 3244. first composite material layer; 3244a. matrix; 3244b. first nano-particles; 3245. second composite material layer; 3245b. second nano-particles; 3246. third composite material layer; 325. surface protection layer;
33. plastic package body; and 40. battery.

### DESCRIPTION OF EMBODIMENTS

In the embodiments of this application, the terms, such as "exemplarily" and "for example", are used to represent giving an example, an illustration, or a description. Any embodiment or design scheme described by using "exemplarily" or "for example" in the embodiments of this application should not be explained as being more preferred or having more advantages than another embodiment or design scheme. In particular, the terms such as "exemplary" and "for example" as used herein are intended to present the related concept in a specific implementation.

In the embodiments of this application, terms "first" and "second" are used merely for the purpose of description, and shall not be construed as indicating or implying relative importance or implying a quantity of indicated technical features. Therefore, a feature limited by "first" or "second" may explicitly or implicitly include one or more of the features.

In the descriptions of the embodiments of this application, the term "at least one" refers to one or more, and "a plurality of" refers to two or more. "At least one of the following items" or a similar expression means any combination of these items, including a single item or any combination of a plurality of items. For example, at least one of a, b, or c may represent: a, b, c, a-b, a-c, b-c, or a-b-c, where a, b, and c may be single or multiple.

"And/or" in the descriptions of the embodiments of this application describes only an association relationship for describing associated objects and represents that three relationships may exist. For example, A and/or B may represent the following three cases: Only A exists, both A and B exist, and only B exists. In addition, the character "/" in this application generally indicates an "or" relationship between the associated objects.

In the descriptions of the embodiments of this application, it should be noted that, unless otherwise explicitly specified or defined, the terms "mount", "connected", and "connection" should be understood in a broad sense. For example, the "connection" may be a detachable connection or an integral connection, or may be a direct connection, or an indirect connection through an intermediary. The "fixed connection" refers to being connected to each other and the relative position relationship after being connected is unchanged. "Rotation connection" refers to being connected to each other and capable of rotating relative to each other after being connected. "Slidable connection" refers to being connected to each other and capable of sliding relative to each other after being connected.

The orientation terms mentioned in the embodiments of this application, for example, "inner", "outer", "upper", "lower", "front", "back", "left", or "right", are only directions with reference to the accompanying drawings. Therefore, the orientation terms used are for better and clearer explanation and understanding of the embodiments of this application, rather than indicating or implying that the apparatus or component referred to need to have a particular orientation, be constructed and operate in a particular orientation, and therefore cannot be construed as limiting the embodiments of this application.

In the embodiments of this application, terms "include", "comprise", and any variants thereof are intended to cover a non-exclusive inclusion. Therefore, in the context of a process, method, object, or apparatus that includes a series of elements, the process, method, object, or apparatus not only includes such elements, but also includes other elements not specified expressly, or may include inherent elements of the process, method, object, or apparatus. Without more limitations, elements defined by the sentence "including one" does not exclude that there are still other same elements in the process, method, object, or apparatus which includes the element.

This application provides an electronic device. The electronic device includes a bare chip. To improve the anti-ionizing radiation capability of the bare chip, in the electronic device in this application, by providing a shield layer on an outer surface of the bare chip, ionizing radiation from the outside of the bare chip can be shielded by using the shield layer, so that the anti-ionizing radiation capability of the bare chip can be significantly improved, and further the anti-ionizing radiation capability of the chip including the bare chip can be improved. On one hand, normal operation of the chip in a harsh environment in which ionizing radiation exists can be ensured. On the other hand, system redundancy design of the chip is not needed, waste of resources can be avoided, and the economic efficiency can be improved. Further, simplification of the package structure of the chip is facilitated, so as to reduce the overall cost of the chip while implementing a miniaturized design of the chip.

The electronic device provided in this application may be a consumer electronic product, a household electronic product, an in-vehicle electronic product, a financial terminal product, a communication electronic product, or the like. The consumer electronic product may be, for example, a mobile phone (mobile phone), a tablet computer (pad), a laptop, an e-reader, a personal computer (personal computer, PC), a personal digital assistant (personal digital assistant, PDA), a desktop display, an intelligent wearable product (for example, a smart watch, or a smart bracelet), a virtual reality (virtual reality, VR) terminal device, an augmented reality (augmented reality, AR) terminal device, or an unmanned aerial vehicle. The household electronic product may be, for example, a smart door lock, television set, remote control, refrigerator, or rechargeable small household appliance (for example, a soybean milk machine, or a sweeping robot). The in-vehicle electronic product may be, for example, an in-vehicle navigator, or an in-vehicle high-density digital video disc (digital video discs, DVD). The financial terminal product may be, for example, an automatic teller machine (automated teller machine, ATM) machine, or a self-service service terminal. The communication electronic product may be a communication device such as a server, a memory, or a base station.

A specific form of the electronic device is not specially limited in this embodiment of this application. For convenience of description, the following embodiments are illustrated by taking an example in which the electronic device is a mobile phone.

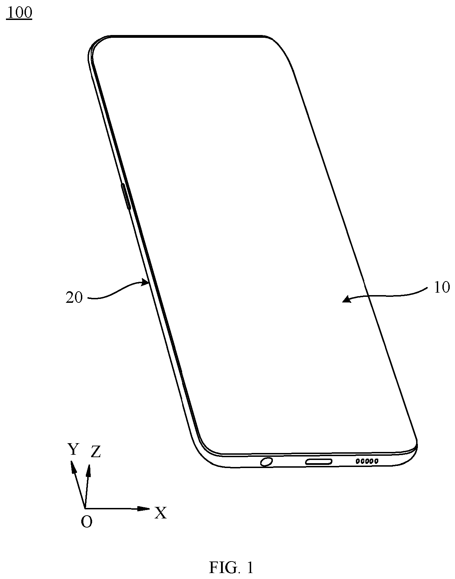

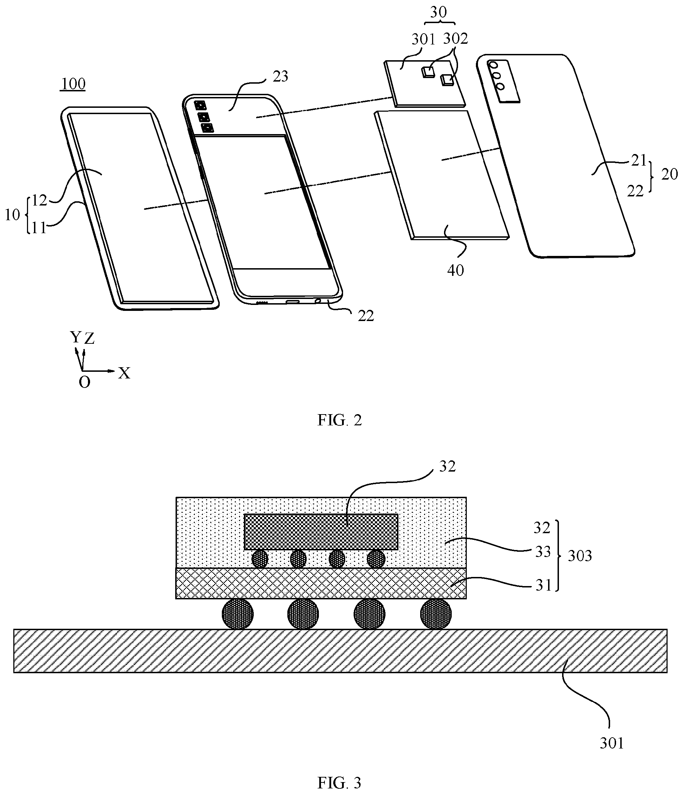

Referring to FIG. 1 and FIG. 2, FIG. 1 is a three-dimensional view of an electronic device 100 according to some embodiments of this application, and FIG. 2 is an exploded view of the electronic device 100 shown in FIG. 1. The electronic device 100 shown in FIG. 1 is described by using a phablet as an example. It may be understood that in other embodiments, the electronic device 100 may alternatively be a foldable mobile phone. Referring to FIG. 1 and FIG. 2, in this example, the electronic device 100 includes a screen 10, a back housing 20, a circuit board assembly 30, and a battery 40.

It may be understood that FIG. 1, FIG. 2, and the following related drawings only schematically show some components included in the electronic device 100, and actual shapes, actual sizes, actual positions, and actual structures of the components are not defined by FIG. 1, FIG. 2, and the following drawings. In addition, when the electronic device 100 is a device of some other forms, the electronic device 100 may not include the screen 10.

In the embodiment shown in FIG. 1, the electronic device 100 has a rectangular plate shape. To facilitate the description of the following embodiments, an XYZ coordinate system is established. Specifically, a width direction of the electronic device 100 is defined as an X-axis direction, a length direction of the electronic device 100 is defined as a Y-axis direction, and a thickness direction of the electronic device 100 is defined as a Z-axis direction.

The screen 10 is configured to display an image, a video, or the like. Referring to FIG. 2, the screen 10 includes a light-transmitting cover plate 11 and a display screen 12. The light-transmitting cover plate 11 and the display screen 12 are stacked. The light-transmitting cover plate 11 is mainly configured to protect the display screen 12 and prevent dust.

Referring to FIG. 2, the back housing 20 includes a back cover 21 and a border frame 22. The back cover 21 is located at a side of the display screen 12 facing away from the light-transmitting cover plate 11, and is stacked with the light-transmitting cover plate 11 and the display screen 12. The border frame 22 is located between the back cover 21 and the light-transmitting cover plate 11, and the border frame 22 is fixed on the back cover 21. The light-transmitting cover plate 11 is fixed on the border frame 22. The light-transmitting cover plate 11, the back cover 21, and the border frame 22 enclose to form an internal accommodating space of the electronic device 100. The internal accommodating space accommodates the display screen 12, the circuit board assembly 30, the battery 40, and the like.

In some embodiments, referring to FIG. 2, the electronic device 100 further includes a middle plate 23. The middle plate 23 is fixed around an inner surface of the border frame 22. The middle plate 23 serves as a structural "skeleton" of the electronic device 100, and the circuit board assembly 30, the battery 40, and the like may be fixed to the middle plate 23.

When the electronic device 100 does not include the middle plate 23, the circuit board assembly 30, the battery 40, and the like may be fixed on a surface of the display screen 12 facing the back cover 21, or may be fixed on an inner surface of the back cover 21.

The battery 40 is configured to provide power to electronic components such as the display screen 12 and the circuit board assembly 30 in the electronic device 100. In some embodiments, a surface of the middle plate 23 facing the back cover 21 is provided with a battery mounting slot, and the battery 40 is mounted in the battery mounting slot.

Referring to FIG. 2, the circuit board assembly 30 includes a circuit board 301 and an electronic component 302. The circuit board 301 may be a printed circuit board (printed circuit board, PCB) or the like. The circuit board 301 is configured to carry the electronic component 302, and complete signal interaction with the electronic component 302. The electronic component 302 includes, but is not limited to, a chip 303 such as a center processing unit (center processing unit, CPU) chip, a radio frequency chip, a radio frequency power amplifier (power amplifier, PA) chip, a system on a chip (system on a chip, SOC), a power management circuit (power management integrated circuit, PMIC), a memory chip (for example, a high bandwidth memory (high bandwidth memory, HBM)), an audio processor chip, a touchscreen control chip, an NAND flash (flash memory), an image sensor chip, or a charging protection chip, a resistor, a capacitor, an inductor, a potentiometer, an electron tube, a radiator, an electromechanical component, a connector, a semiconductor discrete device, a sensor, a power supply, a switch, a micro motor, an electronic transformer, a relay, a SIM card seat, or the like.

Referring to FIG. 3, FIG. 3 is a schematic assembly diagram of a chip 303 and a circuit board 301 according to some embodiments of this application. In this embodiment, the chip 303 is a packaged chip. Specifically, the chip 303 includes a package base plate 31, a bare chip 32, and a plastic package body 33. The bare chip 32 is electrically connected to the package base plate 31, and the plastic package body 33 is disposed on the package base plate 31 and wraps the bare chip 32. The chip 303 may be electrically connected to the circuit board 301 through the package base plate 31. Certainly, the assembly manner of the chip 303 and the circuit board 301 is not limited thereto. In other embodiments, the chip 303 may alternatively be a bare chip 32, and the bare chip 32 is directly and electrically connected to the circuit board 301, which is not limited in the embodiments of this application. The packaged chip refers to a package structure formed after the bare chip 32 is packaged and formed. The bare chip 32 refers to a product form after the semiconductor device is manufactured and before packaging.

A core component of the electronic device 100 is the chip 303, and the stability of the structure of the chip 303 determines the stability and reliability of the electronic device 100. However, in daily life, radiation is everywhere. Sunlight, watching TV, flying, taking an X-ray film, CT in hospitals, X-rays of security detectors at bus stations, airports, and subways, and high-energy ions (for example, neutrons) floating in space are all radiation. Radiation can be divided into ionizing radiation and non-ionizing radiation. The ionizing radiation can directly or indirectly ionize a substance (for example, atoms or molecules gain or lose electrons to become ions). When the chip 303 is used in an environment where ionizing radiation exists, the ionizing radiation is apt to interact with internal electrons of the bare chip 32 in the chip 303, causing the chip 303 to malfunction and affecting the stability and reliability of the chip 303.

For example, a basic unit (that is, a transistor) of a memory chip (Flash) usually uses a floating gate structure, and electrons are captured by the floating gate to store information. When high-energy particles interact with the electrons on the floating gate, a possibility of state error reversal exists, resulting in information loss and soft failure. For registers that need to store firmware, after the state changes, the system cannot start or even a hard failure occurs. Therefore, such client failures can be significantly reduced by improving the resistance of the bare chip 32 to ionizing radiation.

Currently, there are three main types of NAND flashes: a single-level cell (SLC), a multi-level cell (MLC), and a tri-level cell (TLC). As the name suggests, in a same unit area, a TLC flash memory stores more data than an MLC flash memory, and the MLC flash memory stores more data than an SLC flash memory. At present, a mainstream NAND flash memory has transitioned from a planar process to a 3D NAND or V-NAND (vertical NAND). The basic control principle is still a floating gate structure. Each new process technology helps to reduce the voltage and node capacitance. However, the reduced node capacitance is more susceptible to bit failure of the device caused by ionizing radiation.

In the related art, to improve the anti-ionizing radiation capability of the chip 303 and avoid soft failure of the chip 303 due to ionizing radiation, common solutions include algorithm error correction, package shielding, and system redundancy design. The algorithm error correction refers to repairing the chip 303 through a reset or rewrite operation, and an error logic caused by the single particle effect is corrected, so as to achieve the purpose of anti-ionizing radiation. However, in a case of strong ionizing radiation, the algorithm error correction is apt to fail. For package shielding, mainly a metal housing is used or a packaging material wrapped outside the bare chip 32 is improved, to achieve radiation shielding, so as to achieve the purpose of anti-ionizing radiation. However, the package shielding solution may significantly increase the overall volume of the chip 303, which is not conducive to the miniaturization, and further the cost is high. The system redundancy design refers to performing repeated backup of hardware and software systems, is used more in aerospace systems, and has a low economic efficiency and a particular degree of waste of resources.

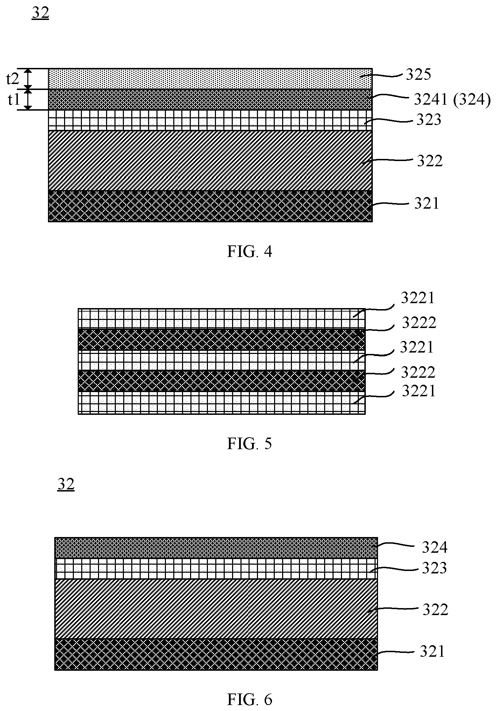

To solve the foregoing technical problem, an embodiment of this application provides a bare chip 32. Referring to FIG. 4, FIG. 4 is a schematic structural diagram of a bare chip 32 according to some embodiments of this application. The bare chip 32 includes a substrate layer 321, a circuit layer 322, an insulation layer 323, and a shield layer 324.

The substrate layer 321 is configured to arrange a transistor. A material of the substrate layer 321 includes, but is not limited to, silicon (Si), germanium (Ge), silicon germanium (SiGe), gallium arsenide (GaAs), gallium nitride (GaN), or the like. The circuit layer 322 is disposed on an active surface of the substrate layer 321.

The circuit layer 322 is configured to implement electrical connection between the bare chip 32 and an external circuit. Referring to FIG. 5, FIG. 5 is a cross-sectional view of a circuit layer 322 of the bare chip 32 shown in FIG. 4. The circuit layer 322 may include a plurality of metal layers 3221 that are spaced apart. The plurality of metal layers 3221 constitute a circuit structure of the chip 303. A dielectric layer 3222 is arranged between two adjacent metal layers 3221. The dielectric layer 3222 is configured to space the metal layers 3221 at different levels in the circuit layer 322. The metal layers 3221 at the different layers may be electrically connected by using metallized vias (not shown). A material constituting the dielectric layer 3222 may include, for example, at least one of prepreg, polyimide (polyimide, PI), polybenzoxazole (polybenzoxazole, PBO), bismaleimide-triazine resin (bismaleimide triazine, BT), or ceramic powder reinforced modified epoxy resin (ajinomoto build up film, ABF).

The insulation layer 323 is disposed on a surface of a side of the circuit layer 322 facing away from the substrate layer 321. The insulation layer 323 is configured to protect the circuit layer 322 and can play a role of moisture-proof, waterproof, and anti-corrosion.

The shield layer 324 is disposed on a surface of a side of the insulation layer 323 facing away from the substrate layer 321. The shield layer 324 is configured to shield ionizing radiation. In this way, the ionizing radiation energy acting on the transistor of the bare chip 32 can be reduced, so that the anti-ionizing radiation capability of the bare chip 32 can be improved, the bare chip 32 can be prevented from soft failure, the reliability and stability of the bare chip 32 can be improved, and the reliability and stability of the chip 303 can be improved.

In this way, in the embodiments of this application, by disposing the shield layer 324 on the insulation layer 323 of the bare chip 32, ionizing radiation from the outside of the bare chip 32 can be shielded through the shield layer 324, so that the anti-ionizing radiation capability of the bare chip 32 can be significantly improved, and further the ionizing radiation resistance capability of the chip 303 can be improved. Therefore, on one hand, normal operation of the chip 303 in a harsh environment in which ionizing radiation exists can be ensured. On the other hand, system redundancy design of the chip 303 is not needed, waste of resources can be avoided, and the economic efficiency can be improved. Further, a metal housing structure of the chip 303 can be omitted, and the material of the package structure of the chip 303 can be improved, so as to reduce the overall cost of the chip 303 while implementing a miniaturized design of the chip 303.

In some embodiments, a thickness of the shield layer 324 is less than or equal to 10 µm. For example, the thickness of shield layer 324 is 10 µm, 9 µm, 8 µm, 7 µm, 6 µm, 5 µm, 4 µm, 3 µm, 2 µm, or 1 µm. In this way, the overall thickness of the bare chip 32 can be reduced while the shielding effect of the shield layer 324 is ensured, thereby facilitating reduction of the overall volume of the chip 303 and facilitating a miniaturized design of the chip 303 and the electronic device 100. A thickness direction of the shield layer may be parallel to a thickness direction of the electronic device.

The specific structure of the shield layer 324 is described in detail below.

Referring to FIG. 4, in this embodiment, the shield layer 324 of the bare chip 32 includes a first film layer 3241. The first film layer 3241 is located on a side of the insulation layer 323 facing away from the substrate layer 321. Specifically, the first film layer 3241 may be disposed on a surface of a side of the insulation layer 323 facing away from the substrate layer 321. In some embodiments, the first film layer 3241 is a compound film layer including a bismuth (Bi) element or a titanium (Ti) element. The bismuth element and the titanium element can generate an electron pair effect with X-rays, and the bismuth element and the titanium element do not interfere with operation of the bare chip 32. By configuring the first film layer 3241 as a compound film layer including the bismuth element (Bi) or the titanium element (Ti), X-rays can be shielded through the first film layer 3241, and damage to the bare chip 32 by high-energy radiation such as X-rays can be reduced, thereby avoiding soft failure of the bare chip 32 and improving the performance stability and reliability of the bare chip 32, and further the performance stability and reliability of the chip 303 can be improved.

For example, the first film layer 3241 may be a bismuth trioxide (Bi2O3) film layer or a barium titanate (BaTiO3) film layer. The Bi2O3 and BaTiO3 have stable physical and chemical properties, low prices, and wide sources, and are easy to obtain.

Specifically, in some embodiments, the first film layer 3241 may be formed on the surface of the insulation layer 323 by a physical vapor deposition method (physical vapor deposition, PVD) such as vacuum sputtering or vacuum evaporation, or the first film layer 3241 may alternatively be formed on the surface of the insulation layer 323 by a chemical vapor deposition method (chemical vapor deposition, CVD). The process is simple and the processing is convenient. The physical vapor deposition method refers to a method for depositing a thin film having a special function on a to-be-deposited surface by a process of gasifying, in a vacuum condition, a surface of a material source (solid or liquid) into gaseous atoms or molecules, or partially ionized into ions by using a physical method and aerating a low-pressure gas (or plasmas). The chemical vapor deposition method mainly refers to a method for generating a thin film by chemical reaction on the to-be-deposited surface by using one or more gas phase compounds or elementary substances containing a thin film element.

In this way, by forming the first film layer 3241 on the surface of the insulation layer 323 by the physical vapor deposition method or the chemical vapor deposition method, a connecting medium for connecting the insulation layer 323 and the first film layer 3241 can be omitted. On one hand, reduction of the overall thickness of the shield layer 324 is facilitated, thereby reducing the overall volume of the bare chip 32 and implementing a miniaturized design of the chip 303. On the other hand, the bonding strength between the insulation layer 323 and the first film layer 3241 can be improved, and the first film layer 3241 can be prevented from falling off from the insulation layer 323, thereby ensuring the shielding effect of the first film layer 3241.

On this basis, to facilitate formation of the first film layer 3241 on the surface of the insulation layer 323 and ensure the bonding strength between the first film layer 3241 and the insulation layer 323, the material of the insulation layer 323 may be silicon dioxide (SiO2), aluminum nitride (AlN), or gallium nitride (GaN). For example, Bi2O3 has four main crystal phases, a most common crystal phase is steady-state α-monoclinic, having a C-axis lattice constant of 5.71 Å, which is close to that of SiO2 (5.5 Å), and a low mismatch. Therefore, Bi2O3 can grow in a direction <001>. Therefore, the degree of matching between the first film layer 3241 and the insulation layer 323 can be improved, and the first film layer 3241 can be conveniently grown on the surface of the insulation layer 323.

In some embodiments, referring to FIG. 4, the thickness t1 of the first film layer 3241 is greater than or equal to 1 µm and less than or equal to 3 µm. For example, the thickness t1 of the first film layer 3241 may be 1 µm, 1.5 µm, 2 µm, 2.5 µm, 3 µm, or the like. In this way, the overall thickness of the bare chip 32 can be reduced while the X-ray shielding effect of the first film layer 3241 is ensured, thereby facilitating a miniaturized design of the chip 303 and the electronic device 100.

In some embodiments, referring to FIG. 4, the bare chip 32 further includes a surface protection layer 325. The surface protection layer 325 is located on a side of the shield layer 324 facing away from the insulation layer 323. Specifically, in this embodiment, the surface protection layer 325 is disposed on a surface of a side of the first film layer 3241 facing away from the insulation layer 323. The surface protection layer 325 can shield the shield layer 324 to prevent the shield layer 324 from being exposed, so that the shield layer 324 can be protected by the surface protection layer 325 to prevent the shield layer 324 from being corroded or affected with moisture.

In some embodiments, the surface protection layer 325 is a polymer material layer. For example, a material of surface protection layer 325 can include, but is not limited to, polyimide (polyimide, PI), polyethylene terephthalate (polyethylene terephthalate, PET), polyethylene (polyethylene, PE), or the like. The polymer material has stable properties and strong corrosion resistance. By disposing the polymer material layer on the shield layer 324 as the surface protection layer 325, the shield layer 324 can be protected by the surface protection layer 325 to prevent the shield layer 324 from being corroded. In addition, the polymer material has good mechanical properties. By disposing the surface protection layer 325 on the shield layer 324, the overall anti-impact capability of the bare chip 32 can further be improved. In addition, the content of hydrogen atoms in the polymer material is relatively high, and the hydrogen atoms interact with the neutrons to reduce the neutron energy to achieve the effect of attenuating and slowing down the neutrons, so that the radiation impact of high-energy particles such as neutrons on the bare chip 32 can be reduced, and further the anti-ionizing radiation capability of the bare chip 32 and the chip 303 can be improved.

Referring to FIG. 4, the thickness t2 of the surface protection layer 325 is greater than or equal to 1 µm and less than or equal to 3 µm. For example, the thickness t2 of the surface protection layer 325 may be 1 µm, 1.5 µm, 2 µm, 2.5 µm, 3 µm, or the like. In this way, the overall thickness of the bare chip 32 can be reduced while the protection effect of the surface protection layer 325 is ensured, thereby facilitating a miniaturized design of the chip 303 and the electronic device 100.

In some embodiments, the surface protection layer 325 may be formed on the surface of the shield layer 324 facing away from the insulation layer by a physical vapor deposition such as vacuum sputtering or vacuum evaporation, a chemical vapor deposition, or a coating (for example, spray coating, or spin coating) method. The process is simple and the processing is convenient.

It may be understood that in other embodiments, The bare chip 32 may not include the surface protection layer 325. For example, referring to FIG. 6, FIG. 6 is a schematic structural diagram of a bare chip 32 according to some other embodiments of this application. In the embodiments shown in FIG. 6, the bare chip 32 is not provided with the foregoing surface protection layer 325.

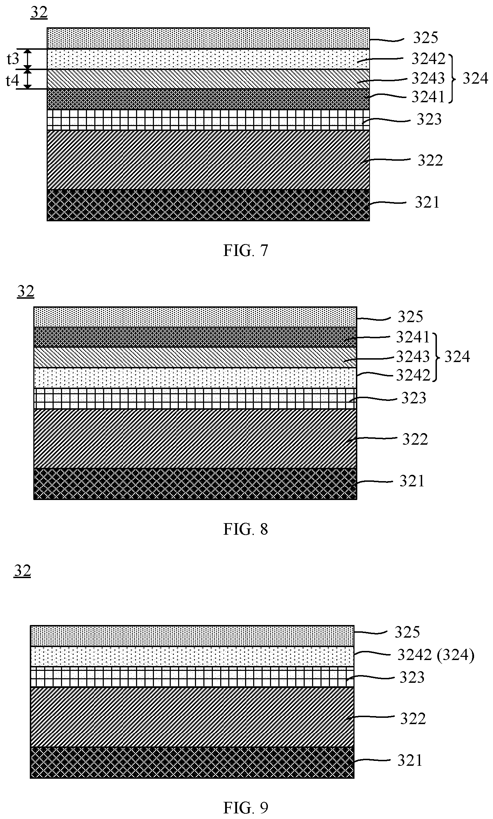

In some other embodiments, referring to FIG. 7, FIG. 7 is a schematic structural diagram of a bare chip 32 according to some other embodiments of this application. The difference between the bare chip 32 in this embodiment and the bare chip 32 in the embodiments shown in FIG. 4 lies in that the shield layer 324 of the bare chip 32 in this embodiment includes a second film layer 3242 in addition to the first film layer 3241.

Specifically, referring to FIG. 7, the second film layer 3242 is disposed on a side of the first film layer 3241 facing away from the insulation layer 323. In some embodiments, the second film layer 3242 is a compound film layer including a boron element (B) or a lithium element (Li). The boron element and the lithium element have a high absorption cross-section for neutrons, and after absorbing neutrons, the boron element and lithium element generate less secondary γ rays, and the boron element and lithium element do not interfere with operation of the bare chip 32 In this way, by configuring the second film layer 3242 as the compound film layer including the boron element or the lithium element, neutrons can be effectively shielded, and the radiation impact of high-energy particles such as neutrons on the bare chip 32 can be reduced, thereby further improving the anti-ionizing radiation capability of the bare chip 32 and the chip 303. Therefore, the shield layer 324 in this embodiment not only can resist high-energy radiation of X-rays, but also can resist high-energy radiation of high-energy particles such as neutrons, so that the bare chip 32 can resist different types of ionizing radiation, thereby significantly improving the anti-ionizing radiation capability of the bare chip 32 and the chip 303.

In some embodiments, the second film layer 3242 may be a boron nitride (BN) film layer or a boron carbide (BC) film layer. The BN and BC have stable physical and chemical properties and wide sources, and are easy to obtain. Specifically, the second film layer 3242 may be formed by using a physical vapor deposition method such as vacuum sputtering or vacuum evaporation, or the second film layer 3242 may alternatively be formed by using a chemical vapor deposition method. The process is simple and the processing is convenient.

In some embodiments, referring to FIG. 7, the thickness t3 of the second film layer 3242 is greater than or equal to 1 µm and less than or equal to 3 µm. For example, the thickness t3 of the second film layer 3242 may be 1 µm, 1.5 µm, 2 µm, 2.5 µm, 3 µm, or the like. In this way, the overall thickness of the bare chip 32 can be reduced while the neutron shielding effect of the second film layer 3242 is ensured, thereby facilitating a miniaturized design of the chip 303 and the electronic device 100.

On this basis, to facilitate formation of the second film layer 3242, continuously referring to FIG. 7, the shield layer 324 further includes a transition layer 3243. The transition layer 3243 is disposed on a surface of a side of the first film layer 3241 facing away from the insulation layer 323. The second film layer 3242 is disposed on a surface of a side of the transition layer 3243 facing away from the first film layer 3241. A material of the transition layer 3243 may be silicon dioxide (SiO2), aluminum nitride (AlN), or gallium nitride (GaN). The transition layer 3243 may be formed by using a physical vapor deposition method such as vacuum sputtering or vacuum evaporation, or the transition layer 3243 may alternatively be formed by using a chemical vapor deposition method. In this way, the transition layer 3243, the first film layer 3241, and the second film layer 3242 can have a high degree of matching. In a processing process, not only the transition layer 3243 can be conveniently formed on the surface of the first film layer 3241 facing away from the insulation layer 323, but also the second film layer 3242 can be conveniently formed on the surface of the transition layer 3243 facing away from the first film layer 3241, so that the connection reliability between the first film layer 3241 and the transition layer 3243 and the connection reliability between the second film layer 3242 and the transition layer 3243 can be improved, and a phenomenon of delaminating and falling off of the shield layer 324 can be avoided; and therefore the stability and reliability of the overall structure of the shield layer 324 can be improved and the shielding effect of the shield layer 324 against ionizing radiation can be ensured.

In some embodiments, referring to FIG. 7, the thickness t4 of the transition layer 3243 is greater than or equal to 1 µm and less than or equal to 3 µm. For example, the thickness t4 of the transition layer 3243 may be 1 µm, 1.5 µm, 2 µm, 2.5 µm, 3 µm, or the like. In this way, the overall thickness of the bare chip 32 can be reduced while the difficulty of forming the second film layer 3242 is reduced, thereby facilitating a miniaturized design of the chip 303 and the electronic device 100.

It may be understood that in other embodiments, the bare chip 32 may not include the foregoing transition layer 3243. In this case, the second film layer 3242 is directly formed on a surface of a side of the first film layer 3241 facing away from the insulation layer 323.

In still some other embodiments, referring to FIG. 8, FIG. 8 is a schematic structural diagram of a bare chip 32 according to still some other embodiments of this application. The difference between the bare chip 32 in this embodiment and the bare chip 32 in the embodiments shown in FIG. 7 lies in that in the embodiments shown in FIG. 7, the second film layer 3242 in the shield layer 324 is located on the side of the first film layer 3241 facing away from the insulation layer 323, and in the embodiment, the first film layer 3241 in the shield layer 324 is located on a side of the second film layer 3242 facing away from the insulation layer 323. That is, in this embodiment, the positions of the first film layer 3241 and the second film layer 3242 of the shield layer 324 are switched with respect to those of the shield layer 324 in the embodiments shown in FIG. 7.

Specifically, referring to FIG. 8, the shield layer 324 includes a first film layer 3241, a transition layer 3243, and a second film layer 3242. The second film layer 3242 is formed on a surface of a side of the insulation layer 323 facing away from the substrate layer 321, the transition layer 3243 is formed on a surface of a side of the second film layer 3242 facing away from the insulation layer 323, and the first film layer 3241 is formed on a surface of a side of the transition layer 3243 facing away from the second film layer 3242. In this way, the shield layer 324 in this embodiment can resist both high-energy radiation of X-rays and high-energy radiation of high-energy particles such as neutrons, so that the bare chip 32 can resist different types of ionizing radiation, thereby significantly improving the anti-ionizing radiation capability of the bare chip 32 and the chip 303 and improving the performance stability and reliability of the chip 303.

In still some other embodiments, referring to FIG. 9, FIG. 9 is a schematic structural diagram of a bare chip 32 according to still some other embodiments of this application. The difference between the bare chip 32 in this embodiment and the bare chip 32 in the embodiments shown in FIG. 8 lies in that the shield layer 324 in this embodiment includes only the second film layer 3242 and does not include the first film layer 3241. In this way, the shield layer 324 in this embodiment can resist high-energy radiation of high-energy particles such as neutrons, similarly can improve the anti-ionizing radiation capability of the bare chip 32 to a particular extent, and further can improve the anti-ionizing radiation capability of the chip 303 to a particular extent.

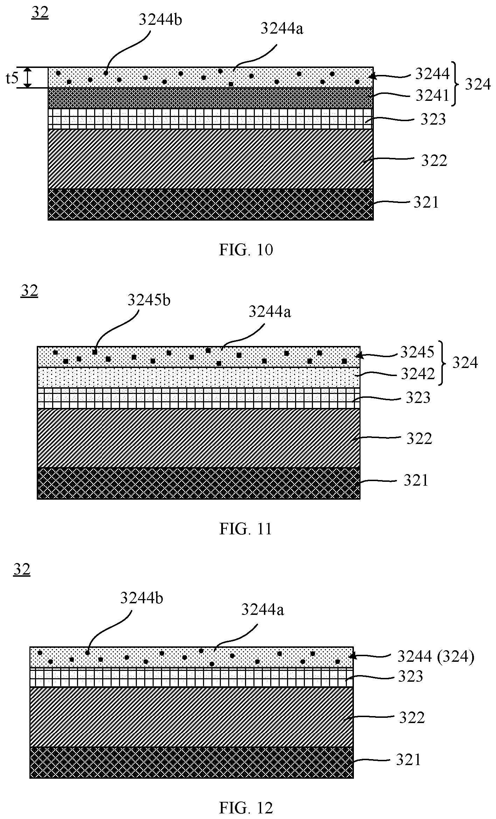

In still some other embodiments, referring to FIG. 10, FIG. 10 is a schematic structural diagram of a bare chip 32 according to still some other embodiments of this application. In this embodiment, the shield layer 324 of the bare chip 32 includes a first film layer 3241 and a first composite material layer 3244. The first film layer 3241 is disposed on a surface of a side of the insulation layer 323 facing away from the substrate layer 321, and the first composite material layer 3244 is disposed on a surface of a side of the first film layer 3241 facing away from the insulation layer 323. The first film layer 3241 is a compound film layer including a bismuth element (Bi) or a titanium element (Ti). The first film layer 3241 may be configured to shield X-rays. The specific material, structure, and preparation method of the first film layer 3241 may be the same as the specific material, structure, and preparation method of the first film layer 3241 in any of the foregoing embodiments. Details are not repeated herein again.

Referring to FIG. 10, the first composite material layer 3244 includes a matrix 3244a and first nano-particles 3244b, and the first nano-particles 3244b are dispersed in the matrix 3244a. The first nano-particles 3244b include at least one of boron nitride nano-particles or boron carbide nano-particles. Optionally, the first nano-particles 3244b are uniformly dispersed in the matrix 3244a.

In this way, neutrons can be absorbed by the boron element in the first composite material layer 3244, so that the radiation impact of high-energy particles such as neutrons on the bare chip 32 can be reduced. Therefore, the shield layer 324 in this embodiment can resist both high-energy radiation of X-rays and high-energy radiation of high-energy particles such as neutrons, so that the bare chip 32 can resist different types of ionizing radiation, thereby significantly improving the anti-ionizing radiation capability of the bare chip 32 and the chip 303. In addition, the first composite material layer 3244 is disposed on a surface of a side of the first film layer 3241 facing away from the insulation layer 323, so that the first film layer 3241 can be prevented from being exposed. Therefore, the first film layer 3241 can be protected by using the first composite material layer 3244, and the first film layer 3241 can be prevented from being affected with moisture or being corroded.

In other words, the first composite material layer 3244 in this embodiment may function as the surface protection layer 325. Therefore, after the first composite material layer 3244 is configured, the surface protection layer 325 in the foregoing embodiments can be omitted, so that the structure of the bare chip 32 can be simplified while the anti-ionizing radiation capability of the bare chip 32 is improved. Alternatively, in other embodiments, the surface protection layer 325 in any of the foregoing embodiments may alternatively be replaced by the first composite material layer 3244.

In some embodiments, the material of the matrix 3244a is a polymer material. For example, the material of the matrix 3244a may include, but is not limited to, at least one of polyimide (polyimide, PI), polyethylene terephthalate (polyethylene terephthalate, PET), or polyethylene (polyethylene, PE). In this way, on one hand, mixing of the first nano-particles 3244b and the matrix 3244a is facilitated, so that the first nano-particles 3244b are dispersed in the matrix 3244a. On the other hand, not only the neutrons can be absorbed by the boron element in the first composite material layer 3244, but also the energy of neutrons can be reduced through interaction between hydrogen atoms in the polymer material and the neutrons, to achieve the purpose of attenuating and slowing the neutrons, so that the shielding effect of the first composite material layer 3244 on the neutrons can be further improved, the radiation impact of the high-energy particles such as the neutrons on the bare chip 32 can be reduced, and further the anti-ionizing radiation capability of the bare chip 32 can be improved and in turn the anti-ionizing radiation capability of the chip 303 can be improved.

For example, the first nano-particles 3244b and a precursor of the matrix 3244a (for example, a precursor polyamic acid of polyimide) may be mixed uniformly by stirring or ultrasonic action to form a first composite material, then the first composite material is coated on the surface of the first film layer 3241 facing away from the insulation layer 323 by a coating process such as spin coating or spray coating, and after high temperature treatment, the first composite material layer 3244 can be formed on the surface. The process is simple, the processing is convenient, and there is no need to dispose a transition layer in the first composite material layer 3244 and the first film layer 3241, so that the structure and processing process of the shield layer 324 can be simplified while the shielding effect of the shield layer 324 is ensured, thereby facilitating reduction of the overall thickness of the shield layer 324, implementing a miniaturized design of the bare chip 32, reducing the processing cost of the bare chip 32, further facilitating a miniaturized design of the chip 303, and reducing the processing cost of the chip 303.

In some embodiments, a particle diameter of the first nano-particles 3244b is less than or equal to 100 nm. In this way, on one hand, mixing between the first nano-particles 3244b and the matrix 3244a is facilitated, thereby facilitating improvement of the degree of dispersion of the first nano-particles 3244b in the matrix 3244a and improvement of the shielding effect of the first composite material layer 3244. On the other hand, the flatness of the surface of the first composite material layer 3244 can be ensured, thereby preventing the first nano-particles 3244b from damaging other structures such as the first film layer 3241 and transistors in the bare chip 32.

Further, to reduce the processing difficulty of the first nano-particles 3244b, the particle diameter of the first nano-particles 3244b is greater than or equal to 50 nm. For example, the particle diameter of the first nano-particles 3244b is 100 nm, 95 nm, 90 nm, 85 nm, 80 nm, 75 nm, 70 nm, 65 nm, 60 nm, 55 nm, 50 nm, or the like.

In some embodiments, referring to FIG. 10, a thickness t5 of the first composite material layer 3244 is greater than or equal to 1 µm and less than or equal to 5 µm. For example, the thickness t5 of the first composite material layer 3244 may be 1 µm, 1.5 µm, 2 µm, 2.5 µm, 3 µm, 3.5 µm, 4 µm, 4.5 µm, 5 µm, or the like. In this way, the overall thickness of the bare chip 32 can be reduced while the shielding effect of the first composite material layer 3244 can be ensured, thereby facilitating a miniaturized design of the chip 303.

In still some other embodiments, referring to FIG. 11, FIG. 11 is a schematic structural diagram of a bare chip 32 according to still some other embodiments of this application. In this embodiment, the shield layer 324 of the bare chip 32 includes a second film layer 3242 and a second composite material layer 3245. The second film layer 3242 is disposed on a surface of a side of the insulation layer 323 facing away from the substrate layer 321, and the second composite material layer 3245 is disposed on a surface of a side of the second film layer 3242 facing away from the insulation layer 323. The second film layer 3242 is a compound film layer including a boron element (B) or a lithium element (Li). The second film layer 3242 may be configured to shield neutrons. The specific material, structure, and preparation method of the second film layer 3242 may be the same as the specific material, structure, and preparation method of the second film layer 3242 in any of the foregoing embodiments. Details are not repeated herein again.

Referring to FIG. 11, the second composite material layer 3245 includes a matrix 3244a and second nano-particles 3245b, and the second nano-particles 3245b are dispersed in the matrix 3244a. The second nano-particles 3245b include at least one of bismuth trioxide nano-particles, or barium titanate nano-particles. Optionally, the second nano-particles 3245b are uniformly dispersed in the matrix 3244a. The particle diameter of the second nano-particles 3245b may be greater than or equal to 50 nm and less than or equal to 100 nm.

In this way, X-rays can be shielded by the bismuth element or the titanium element in the second composite material layer 3245, and the impact of high-energy particles such as X-rays on the bare chip 32 can be reduced. Therefore, the shield layer 324 in this embodiment can resist both high-energy radiation of X-rays and high-energy radiation of high-energy particles such as neutrons, so that the bare chip 32 can resist different types of ionizing radiation, thereby significantly improving the anti-ionizing radiation capability of the bare chip 32 and the chip 303. In addition, the second composite material layer 3245 is disposed on a surface of a side of the second film layer 3242 facing away from the insulation layer 323, so that the second film layer 3242 can be prevented from being exposed. Therefore, the second film layer can be protected by using the second composite material layer 3245, and the second film layer 3242 can be prevented from being affected with moisture or corroded.

In other words, the second composite material layer 3245 in this embodiment may function as the surface protection layer 325. Therefore, after the second composite material layer 3245 is configured, the surface protection layer 325 in the foregoing embodiments can be omitted, so that the structure of the bare chip 32 can be simplified while the anti-ionizing radiation capability of the bare chip 32 is improved. Alternatively, in other embodiments, the surface protection layer 325 in any of the foregoing embodiments may alternatively be replaced by the second composite material layer 3245.

In this embodiment, the material of the matrix 3244a in the second composite material layer 3245 may be the same as the material of the matrix 3244a in the first composite material layer 3244 in the embodiments shown in FIG. 10, the method for preparing the second composite material layer 3245 may be the same as that of the first composite material layer 3244, and the thickness of the second composite material layer 3245 may be the same as that of the first composite material layer 3244. Details are not repeated herein again.

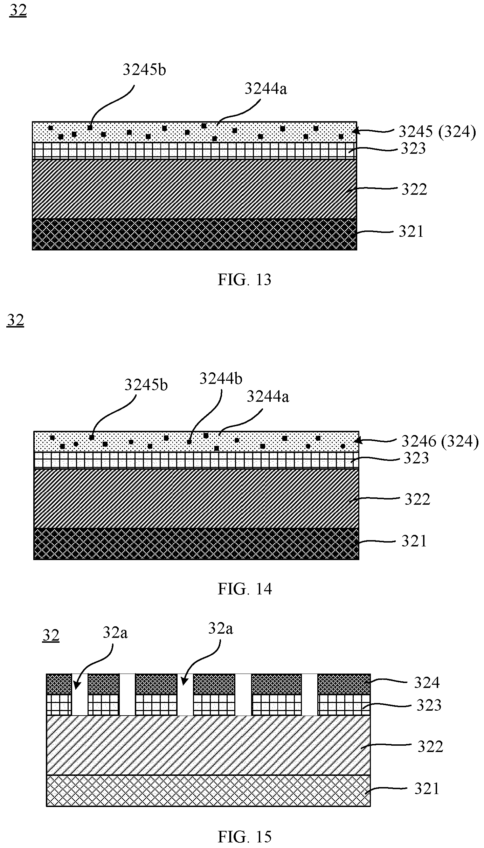

In still some other embodiments, the shield layer 324 may include only the first composite material layer 3244, or the shield layer 324 may include only the second composite material layer 3245. For example, referring to FIG. 12, FIG. 12 is a schematic structural diagram of a bare chip 32 according to still some other embodiments of this application. In the embodiments shown in FIG. 12, the shield layer 324 includes a first composite material layer 3244. The first composite material layer 3244 is disposed on a surface of a side of the insulation layer 323 facing away from the substrate layer 321. Still for example, referring to FIG. 13, FIG. 13 is a schematic structural diagram of a bare chip 32 according to still some other embodiments of this application. In the embodiments shown in FIG. 13, the shield layer 324 includes a second composite material layer 3245, and the second composite material layer 3245 is disposed on a surface of a side of the insulation layer 323 facing away from the substrate layer 321. In this way, the anti-ionizing radiation capability of the bare chip 32 can similarly be improved to a particular extent, so that the anti-ionizing radiation capability of the chip 303 can be improved to a particular extent.

In still some other embodiments, referring to FIG. 14, FIG. 14 is a schematic structural diagram of a bare chip 32 according to still some other embodiments of this application. The shield layer 324 in this embodiment is no longer provided with the first film layer 3241 and the second film layer 3242, but is provided with a third composite material layer 3246 including the matrix 3244a, the first nano-particles 3244b, and the second nano-particles 3245b.

Specifically, the third composite material layer 3246 is disposed on a surface of a side of the insulation layer 323 facing away from the substrate layer 321. The first nano-particles 3244b and the second nano-particles 3245b in the third composite material layer 3246 are dispersed in the matrix 3244a. The material and particle diameter of the first nano-particles 3244b may be the same as the material and particle diameter of the first nano-particles 3244b in the foregoing embodiments, the material and particle diameter of the second nano-particles 3245b may be the same as the material and particle diameter of the second nano-particles 3245b in the foregoing embodiments, and the material of the matrix 3244a may be the same as the material of the matrix 3244a in the foregoing embodiments. Details are not repeated herein again.

Therefore, the shield layer 324 in this embodiment can resist both high-energy radiation of X-rays and high-energy radiation of high-energy particles such as neutrons, so that the bare chip 32 can resist different types of ionizing radiation, thereby significantly improving the anti-ionizing radiation capability of the bare chip 32 and the chip 303. In addition, the structure of the shield layer 324 in this embodiment is simple, which is more conducive to reducing the overall thickness of the shield layer 324 and implementing a miniaturized design of the chip 303 and the electronic device 100.

It may be understood that the third composite material layer 3246 in this embodiment may alternatively be applied to the bare chip 32 in any of the foregoing embodiments, or the third composite material layer 3246 in this embodiment may replace the surface protection layer 325, the first composite material layer 3244, or the second composite material layer 3245 in the foregoing embodiments.

On the basis of any one of the foregoing embodiments, to facilitate electrical connection between the bare chip 32 and an external circuit (for example, the package base plate 31 or the circuit board 301), referring to FIG. 15, FIG. 15 is a schematic structural diagram of a bare chip according to still some other embodiments of this application. After the shield layer 324 is formed on the bare chip 32, or after the shield layer 324 and the surface protection layer 325 are formed on the chip 303, the bare chip 32 may be exposed → developed → etched to form a hollow structure 32a on the bare chip 32, so that a part of the circuit structure of the circuit layer 322 is exposed. The specific operation processes of the foregoing exposure, development, and etching are well known to a person skilled in the art. Details are not repeated herein again.

In the embodiments of this application, the bare chip 32 is provided with the shield layer 324, so that the anti-ionizing radiation capability of the bare chip 32 can be significantly improved, thereby avoiding soft failure and improving the performance stability and reliability of the chip 303. When the bare chip 32 or the chip 303 including the bare chip 32 is applied to the electronic device 100, normal operation of the electronic device 100 in a harsh environment with ionizing radiation can be ensured.

In the descriptions of this specification, the specific features, structures, materials, or characteristics may be combined in a proper manner in any one or more of the embodiments or examples.

Finally, it should be noted that: the foregoing embodiments are merely used for describing the technical solutions of the embodiments of this application, but are not intended to limit the embodiments of this application. Although the embodiments of this application are described in detail with reference to the foregoing embodiments, it should be appreciated by a person of ordinary skill in the art that, modifications may still be made to the technical solutions described in the foregoing embodiments, or equivalent replacements may be made to the part of the technical features, and these modifications or replacements will not cause the essence of corresponding technical solutions to depart from the spirit and scope of the technical solutions in the embodiments of this application.

## Claims

1. A bare chip, comprising:
a substrate layer;
a circuit layer, wherein the circuit layer is disposed on a surface of a side of the substrate layer;
an insulation layer, wherein the insulation layer is disposed on a surface of a side of the circuit layer facing away from the substrate layer; and
a shield layer, wherein the shield layer is disposed on a surface of a side of the insulation layer facing away from the substrate layer and the shield layer is configured to shield ionizing radiation.

2. The bare chip according to claim 1, wherein the shield layer comprises a first film layer and the first film layer is a compound film layer comprising a bismuth element or a titanium element.

3. The bare chip according to claim 2, wherein the first film layer is a bismuth trioxide film layer or a barium titanate film layer.

4. The bare chip according to claim 2 or 3, wherein the shield layer comprises a second film layer, the second film layer is a compound film layer comprising a boron element or a lithium element, and the second film layer is located on a side of the first film layer facing away from the insulation layer, or the first film layer is located on a side of the second film layer facing away from the insulation layer.

5. The bare chip according to claim 4, wherein the second film layer is a boron nitride film layer or a boron carbide film layer.

6. The bare chip according to claim 4 or 5, wherein the shield layer further comprises a transition layer, the first film layer and the second film layer are fixedly connected to two opposite sides of the transition layer respectively, and a material of the transition layer is silicon dioxide, aluminum nitride, or gallium nitride.

7. The bare chip according to claim 2 or 3, wherein the shield layer comprises a first composite material layer, the first composite material layer is disposed on a surface of a side of the first film layer facing away from the insulation layer, the first composite material layer comprises a matrix and first nano-particles, the first nano-particles are dispersed in the matrix, and the first nano-particles comprise at least one of boron nitride nano-particles or boron carbide nano-particles.

8. The bare chip according to claim 7, wherein a material of the matrix is a polymer material.

9. The bare chip according to any one of claims 1 to 8, wherein the bare chip further comprises a surface protection layer and the surface protection layer is disposed on a surface of a side of the shield layer facing away from the insulation layer.

10. The bare chip according to claim 1, wherein the shield layer comprises a second film layer, the second film layer is located on a side of the insulation layer facing away from the substrate layer, and the second film layer is a compound film layer comprising a boron element or a lithium element.

11. The bare chip according to claim 10, wherein the shield layer comprises a second composite material layer, the second composite material layer is disposed on a surface of a side of the second film layer facing away from the insulation layer, the second composite material layer comprises a matrix and second nano-particles, the second nano-particles are dispersed in the matrix, and the second nano-particles comprise at least one of bismuth trioxide nano-particles or barium titanate nano-particles.

12. The bare chip according to claim 1, wherein the shield layer comprises a third composite material layer, the third composite material layer is disposed on a side of the insulation layer facing away from the substrate layer, the third composite material layer comprises a matrix, first nano-particles, and second nano-particles, the first nano-particles and the second nano-particles are dispersed in the matrix, the first nano-particles comprise at least one of boron nitride nano-particles or boron carbide nano-particles, and the second nano-particles comprise at least one of bismuth trioxide nano-particles or barium titanate nano-particles.

13. The bare chip according to claim 12, wherein a particle diameter of the first nano-particles is greater than or equal to 50 nm and less than or equal to 100 nm, and/or a particle diameter of the second nano-particles are greater than or equal to 50 nm and less than or equal to 100 nm.

14. The bare chip according to any one of claims 1 to 13, wherein a thickness of the shield layer is less than or equal to 10 µm.

15. A chip, comprising:
a package base plate;
a bare chip, wherein the bare chip is electrically connected to the package base plate and the bare chip is the bare chip according to any one of claims 1 to 14; and
a plastic package body, wherein the plastic package body is disposed on the package base plate and the plastic package body is wrapped outside the bare chip.

16. An electronic device, comprising:
a circuit board, and
a chip, wherein the chip is electrically connected to the circuit board, and the chip is the chip according to claim 15.
